# EUROPEAN PATENT APPLICATION

(11) **EP 1 519 264 A2**
(43) Date of publication of application: **30.03.2005**
(21) Application number: 04020663.3
(22) Date of filing: 31.08.2004
(51) Int. Cl.: G06F 3/16

(54) **Electronic apparatus that allows speaker volume control based on surrounding sound volume and method of speaker volume control**

(30) Priority: 26.09.2003 JP 2003336215
(71) Applicant: Kabushiki Kaisha Toshiba, Tokyo 105-8001 (JP)
(72) Inventor: Yamazaki, Hiroshi, Toshiba Co., Minato-ku Tokyo 105-8001 (JP); Hanada, Toru, Toshiba Co., Minato-ku Tokyo 105-8001 (JP)
(74) Representative: Henkel, Feiler & Hänzel

(57) **Abstract**

When power is turned on, a speaker volume control section (141) obtains the volume of surrounding sound from a microphone (191) and then determines the output volume of a speaker (192) from the volume of surrounding sound. The speaker volume control section (141) then displays the value of the output volume of the speaker (192) thus determined on an LCD (15). After that, the speaker volume control section (141) monitors whether or not an operation of changing the speaker volume is performed and, when such an operation is not performed for a predetermined period of time, presents the determined speaker volume to a sound controller (19). When an operation of changing the speaker volume is performed, the speaker volume control section (141) presents a volume specified by the user to the sound controller (19).

## Description

The present invention relates to a technique to control the output volume of a speaker used in an electronic apparatus such as a personal computer.

In recent years, electronic apparatuses, such as notebook computers, personal digital assistant (PDA) terminals, etc., which are battery-powered and easy to carry have come into wide use. Many of these types of electronic apparatuses are equipped with sound functions including a sound input function using a microphone and a sound output function using a speaker, allowing users to record simple voice'memos and to listen to music.

Since such electronic apparatuses are made easy to carry, it is quite possible for users to use them at places where they have gone or during movement. That is, it is not a special thing that the electronic apparatuses are used in silent environments or noisy environments according to the time and circumstances. Meanwhile, the speaker volume used in the sound function is usually adjusted by the user. Therefore, when the user moves from a silent environment to a noisy environment or vice versa, he or she has to change manually the speaker volume immediately after power to the apparatus is turned on.

In view of such circumstances, a personal computer has been recently devised which is adapted to automatically control the loudness of sound produced by the speaker on the basis of the volume of surrounding sound picked up by the microphone (see, for example, Japanese Unexamined Patent Publication No. 6-51940). According to this personal computer, when the user moves from a silent environment to a noisy environment, the speaker volume is automatically increased. When the user moves from a noisy environment to a silent environment, on the other hand, the speaker volume is automatically reduced. Thus, the user can be freed from the work of changing the speaker volume.

The personal computer disclosed in the aforementioned Patent Publication assumes sound output from the speaker to be beep sound. Since the beep sound is used to notify the user of the occurrence of some event, even if its volume fluctuates to some extent in a short period, it is not a serious problem. However, when the user listens to music or language-learning voice, it is preferable that the speaker volume be kept at a constant level regardless of surroundings. Even if the environment has changed, frequent fluctuation of the speaker volume would reduce the usability of the apparatus.

Even in noisy environments, many users will not desire that the speaker volume should be inevitably increased. Likewise, even in silent environments, many users do not desire that the speaker volume should be inevitably lowered.

It is therefore an object of the present invention to provide an electronic apparatus and a speaker volume control method which allow the output volume of a speaker to be controlled according to the volume of surrounding sound without impairing ease of use.

To achieve the object, the present invention provides an electronic apparatus characterized by comprising: a microphone; a speaker; determination means for determining the value of output volume of the speaker according to the volume of sound picked by the microphone; display means for displaying the value of output volume of the speaker determined by the determination means; and control means for setting the displayed volume value as the output volume of the speaker when a given operation is not performed for a predetermined period of time after the value of output volume of the speaker has been displayed by the display means.

In this electronic apparatus, for example, when the power is turned on, the output volume of the speaker corresponding to the volume of surrounding sound picked by the microphone is presented to the user. If, for example, a specific key is not pressed by the user, that output volume of the speaker presented to the user is adopted as the current speaker volume. If, on the other hand, the specific key is pressed, a selection panel is displayed which allows the user to select an arbitrary speaker volume.

Thereby, user-friendly speaker volume control is implemented which is such that the environment-dependent speaker volume is presented to the user as a recommended value and the speaker volume can be changed with a simple operation.

Thus, the present invention can provide an electronic apparatus and a speaker volume control method which allows the output volume of a speaker to be controlled according to the volume of surrounding sound without impairing ease of use.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a schematic block diagram of an electronic apparatus according to an embodiment of the present invention;
FIG. 2 shows the contents of a threshold table in the speaker volume control section in the electronic apparatus of FIG. 1;
FIG. 3 shows an algorithm for the speaker volume control section to determine speaker volume Z from surrounding volume Y and threshold values X;
FIG. 4 shows a display form of the speaker volume on the LCD by the speaker volume control section;
FIG. 5 shows a panel displayed in order for the speaker volume control section to prompt the user to select a speaker volume; and
FIG. 6 is a flowchart illustrating the flow of speaker volume control carried out in the electronic apparatus of FIG. 1.

An embodiments of the present will be described hereinafter with reference to the accompanying drawings.

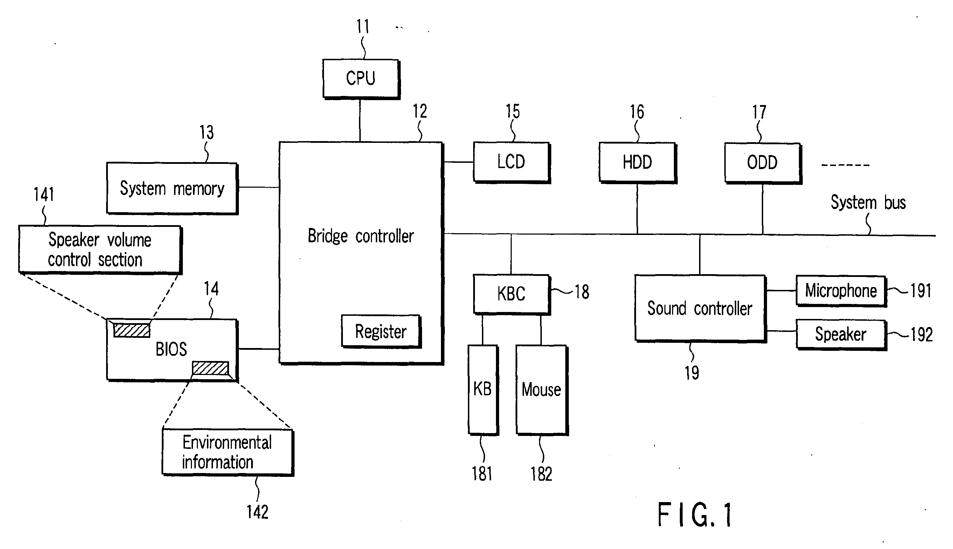

FIG. 1 schematically shows, in block diagram form, an electronic apparatus embodying the present invention.

This electronic apparatus is, for example, a notebook personal computer and is subject to overall control by a CPU 11. The CPU 11 is connected to a high-speed local bus. A bridge controller 12 provides a bridge function of interconnecting the CPU local bus and a system bus laid inside the apparatus.

To the bridge controller 12 are connected a system memory 13 and a BIOS-ROM 14. The bridge controller 12 has a function of controlling access to these components. The bridge controller has a register built in and accepts instructions from the outside via this register.

The system memory 13, which is a storage medium that serves as main storage of the electronic apparatus, temporarily stores various programs executed by the CPU 11 and various data utilized in the programs. The BIOS-ROM 14, which is a storage medium that stores BIOS (Basic I/O System), comprises a program-rewritable flash memory. In the description which follows, the BIOS itself stored in the BIOS-ROM 14 may be sometimes described as BIOS 14. The BIOS 14 has a speaker volume control section 141 and a storage area to store environmental information 142 that indicates various settings concerning operating environments of the electronic apparatus. The environmental information stored in the storage area includes the output volume of a speaker 19 to be described later. The BIOS 14 has a user interface to set the operating environments.

The bridge controller 12 functions as a display controller as well and displays image data created by the CPU 11 on an liquid crystal display (LCD) 15. To the system bus interconnected by the bridge controller 12 to the CPU local bus are connected a hard disk drive (HDD) 16, an optical disk drive (ODD) 17, a keyboard controller (KBC) 18, and a sound controller 19.

The HDD 16 and the ODD 17, which are storage media serving as external storage of the electronic apparatus, store a large number of programs and various data as auxiliary storage for the system memory 13. The KBC 18 transmits user operations on a keyboard 181 and a mouse 182 to the CPU 11. The sound controller 19 transfers sound picked up by a microphone 191 to the CPU 11 through analog-to-digital conversion and transfers sound data from the CPU 11 to the speaker 192 through digital-to-analog conversion.

The volume of sound produced by the speaker 192 is adjusted by the sound controller 19, and the sound controller 19 is controlled by the speaker volume control section 141 in the BIOS 14. The electronic apparatus of this embodiment is characterized in that the output volume of the speaker 192 is controlled appropriately by the speaker volume control section 141. This will be described in detail below.

When the power is applied to the electronic apparatus, system initialization and activation of the operating system are performed by the BIOS 14. After the system initialization and before the operating-system activation, the speaker volume control section 141 in the BIOS 14 carries out control of the output volume of the speaker 192 in accordance with the following procedure:

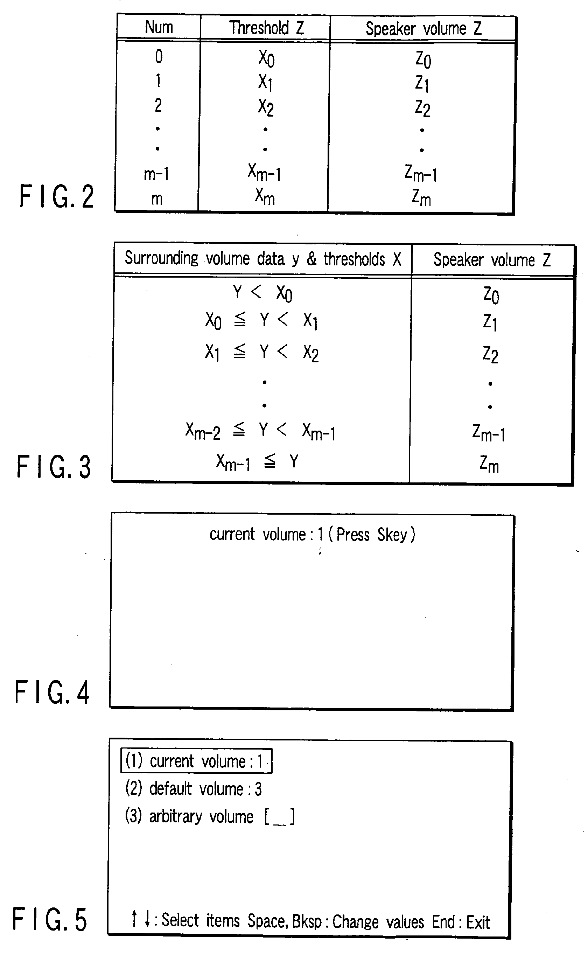

First, the speaker volume control section 141 obtains the volume of surrounding sound from the microphone 191. For example, in crowded trains, a greater volume of sound will be obtained than in rooms. Then, the speaker volume control section 141 determines the output volume of the speaker 192 on the basis of the volume of surrounding sound. To make this determination, the speaker volume control section 141 has such a threshold table as shown in FIG. 2. In this threshold table, threshold values X are mapped into speaker volumes Z as shown in FIG. 2. Using this threshold table, the speaker volume control section 141 determines the speaker volume Z from the obtained surrounding sound volume Y. FIG. 3 shows an algorithm to select the speaker volume Z through comparisons of the surrounding sound volume Y with the threshold values X.

For example, when the obtained surrounding volume Y is less than the threshold value X0, the speaker volume control section 141 selects Z0 as the speaker volume. When Y is more than or equal to X0 but less than X1, Z1 is selected as the speaker volume. When Y is more than or equal to X1 but less than X2, Z2 is selected as the speaker volume. In this way, the speaker volume Z that corresponds to the surrounding sound volume Y is selected.

Upon determining the output volume of the speaker 192, the speaker volume control section 141 temporarily adopts the speaker volume Z and presents it to the sound controller 19. After that, the speaker volume control section 141 transmits sound data for a so-called sound logo or sound data for a beep to the sound controller 19. The usual logo is a mark that is recognized visually by the user, whereas the sound logo is an audio identification that is recognized audibly by the user. Thereby, the sound logo or beep is output from the speaker 192 with the temporarily adopted volume. At substantially the same time, the speaker volume control section 141 displays the volume value as a recommended value on the LCD 15. FIG. 4 shows an exemplary display form of the volume value. Suppose here that, since the obtained surrounding sound volume Y is more than or equal to the threshold X0 but less than the threshold X1, the speaker output volume Z1 is selected and consequently the sequential number "1" for Z1 on the threshold table is displayed.

After the output volume of the speaker 192 determined based on the surrounding sound volume obtained through the microphone 191 has been displayed as the current volume on the LCD 15 as shown in FIG. 4, the speaker volume control section 14 waits idly for a given period of time (for example, five seconds). If a specific key is not pressed within this period of time, then the speaker volume control section 141 terminates the speaker volume control. That is, if no action is taken, the temporarily adopted volume recommended value to be set as the current speaker volume. As a result, after the operating system has been started, the volume of any sound output from the speaker 191 will become the volume determined according to the volume of surrounding sound picked up by the microphone 191. Here, the S key on the KB 181 is defined as the specific key. In FIG. 4, the words (Press S key) are displayed to indicate to the user a method of operation when he or she desires to change the speaker volume.

If, after listening to the sound logo or beep or viewing the recommended volume value displayed on the LCD 15, the user desires to change the volume, he or she simply presses the S key on the KB 181 within the given period of time. Upon receiving via the KBC 18 notification that the S key has been pressed, the speaker volume control section 141 causes such a panel as shown in FIG. 5 to appear on the LCD 15.

This panel is one to allow the user to makes a selection from speaker volumes. As shown in FIG. 5, in addition to the volume recommended value ((1) current volume) determined by the speaker volume control section 141 according to the volume of surrounding sound picked by the microphone 191, the initial value of volume ((2) default volume) preset by the user and stored in the environmental information 142 and the volume the user specifies occasionally and arbitrarily ((3) arbitrary volume) are displayed as options. In the display area for the last option (3), an area is provided to allow the user to enter a desired volume value.

If, on the selection panel, the user selects (2), the user-preset initial value can be set as the speaker volume regardless of the environment at that time. If the user selects (3), he or she can set an arbitrary value as the speaker volume according to circumstances at that time without sticking to the recommended value presented from the speaker volume control section 141.

When a change is made to the speaker volume on the screen shown in FIG. 5, the speaker volume control section 141 presents the new speaker volume to the sound controller 19. Thereby, when any sound is output from the speaker 192 after the operating system has been started, its volume becomes a user-selected one, i.e., either the preset initial volume or the arbitrarily set volume.

The speaker volume control section 141 will not reflect the speaker volume determined according to the above procedure in the environmental information 142. It is the initial volume value set actively by the user that is always stored in the environmental information 142.

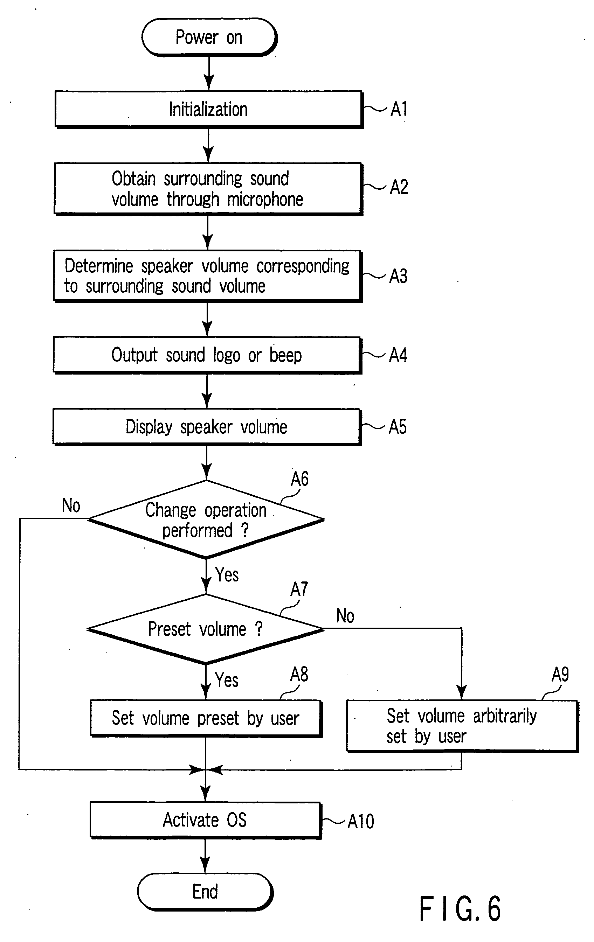

FIG. 6 is a flowchart illustrating the flow of speaker volume control performed in the electronic apparatus of this embodiment.

When the power is applied to the apparatus, system initialization is carried out by the BIOS 14 (step A1). After that, the speaker volume control section 141 first obtains the volume of surrounding sound picked by the microphone 191 (step A2) and then determines the output volume of the speaker 192 on the basis of the volume of surrounding sound obtained in step A2 (step A3).

The speaker volume control section 141 presents the speaker volume thus determined to the sound controller 19, then transmits sound data for sound logo or beep to the sound controller 19 (step A4) and displays the value of output volume of the speaker 192 determined from the volume of surrounding sound on the LCD 15 (step A5).

After the speaker volume has been displayed on the LCD 15, the speaker volume control section 141 monitors whether or not an operation of changing the speaker volume has been performed (step A6). If such an operation has been performed (YES in step A6), then the speaker volume control section makes a decision of whether or not the operation is to change the speaker volume from the volume determined from the volume of surrounding sound to the preset volume (step A7).

If the decision is that the operation is to change the speaker volume to the preset volume (YES in step A7), then the speaker volume control section 141 presents the user-preset volume stored as the environment information 142 to the sound controller 19 (step A8). If, on the other hand, the operation is not to change the speaker volume to the preset volume (NO in step A7), that is, when the user specifies a speaker volume arbitrarily, then the speaker volume control section 141 presents the user-specified volume to the sound controller 19 (step A9).

At the termination of setting of the speaker volume by the speaker volume control section 141, the BIOS 14 starts the operating system and passes control to it (step A10).

Thus, the electronic apparatus of the present invention provides user-friendly speaker volume control such that the environment-dependent speaker volume is presented to the user as a recommended value and the speaker volume can be changed with a simple operation.

Although the embodiment has been described in terms of a specific example in which, at the time when the power to the electronic apparatus is turned on, the speaker volume control section 141 operates to control the output volume of the speaker 192, this is not restrictive. Control of the speaker volume by the speaker volume control section 141 may be performed not only when the power to the electronic apparatus is turned on but also at any other time. For example, the electronic apparatus may be configured such that the BIOS 14 monitors key entry and causes the speaker volume control section 141 to operate when a specific key is pressed on the KB 181. In such a case, when the user moves between considerably different environments, he or she can obtain a recommended value for the speaker volume by pressing the specific key and make a change in the speaker volume with reference to the recommended value. Furthermore, the BIOS 14 may be set to determine whether or not to operate the speaker volume control section 141 when the power is applied to the electronic apparatus.

Although the embodiment has been described in terms of a specific example of first presenting a recommended value for the speaker volume to the user and then, when a given operation is performed, causing a screen to appear on which the user is allowed to change the speaker volume to the initial or other value, the recommended value, the initial value and so on may be displayed at a time as options.

## Claims

1. An electronic apparatus **characterized by** comprising:
a microphone (191);
a speaker (192);
determination means (141) for determining the value of output volume of the speaker according to the volume of sound picked by the microphone;
display means (141) for displaying the value of output volume of the speaker determined by the determination means; and
control means (141) for setting the displayed volume value as the output volume of the speaker when a given operation is not performed for a predetermined period of time after the value of output volume of the speaker has been displayed by the display means.

2. The electronic apparatus according to claim 1, **characterized by** further comprising:
setting means (141) for setting an initial value of output volume of the speaker; and
selection menu display means (141) for displaying a panel which allows the user to select either the volume value determined by the determination means or the initial volume value set by the setting means when the given operation is performed within the predetermined period of time after the volume value has been displayed by the display means, and wherein the control means sets the volume value selected on the panel displayed by the selection panel display means as the output volume of the speaker.

3. The electronic apparatus according to claim 2, **characterized in that**
the selection panel display means provides on the panel an option by which the user is allowed to specify a speaker volume value arbitrarily, and
the control means sets a specified volume value as the output volume of the speaker when the user specifies an arbitrary volume value through the option.

4. The electronic apparatus according to claim 2, **characterized by** further comprising a register (142) which stores data indicating the initial volume value set by the setting means, and
the control means does not update the data stored in the register even when the volume value determined by the determination means is selected on the panel displayed by the selection panel display means.

5. The electronic apparatus according to claim 1, **characterized by** further comprising system control means (141) for operating the determination means, the display means and the control means at the time the electronic apparatus is activated.

6. The electronic apparatus according to claim 5, **characterized in that** the system control operates the determination means, the display means and the control means as requested by the user.

7. The electronic apparatus according to claim 5, **characterized in that** the system control sets whether or not to operate the determination means, the display means and the control means at the time the electronic apparatus is activated.

8. A speaker output volume control method for use in an electronic apparatus equipped with a microphone and a speaker, **characterized by** comprising the steps of:
determining (A2) a value of output volume of the speaker according to a volume of sound picked by the microphone;
displaying (A5) the determined value of output volume of the speaker; and
setting the displayed volume value as the output volume of the speaker when a given operation is not performed for a predetermined period of time.

9. The speaker output volume control method according to claim 8, **characterized by** further comprising the step of:
displaying a panel which allows the user to select either the determined volume value or a preset initial volume value when the given operation is performed within the predetermined period of time after the volume value has been displayed, the volume value selected on the panel being set as the output volume of the speaker.

10. The speaker output volume control method according to claim 9, **characterized in that** an option is provided on the panel by which the user is allowed to specify a speaker volume value arbitrarily, and a specified volume value is set as the output volume of the speaker when the user specifies an arbitrary volume value through the option.
